# EUROPEAN PATENT APPLICATION

(11) **EP 4 060 410 A1**
(43) Date of publication of application: **21.09.2022**
(21) Application number: 21163296.3
(22) Date of filing: 17.03.2021
(51) Int. Cl.: G03F 7/20, H01L 23/538, H01L 23/00

(54) **DIGITAL DIRECT RECORDING DEVICE COMPRISING REAL TIME ANALYSIS AND CORRECTION OF RECORDED ARTWORK BY DIVIDING THE ARTWORK INTO SUBMODULES**

(71) Applicant: Visitech Lithography AS, 3402 Lier (NO)
(72) Inventor: KIRKHORN, Endre, N-3031 Drammen (NO); Solberg, Håkon, N-3047 DRAMMEN (NO); DAAE, John, N-1387 Asker (NO)
(74) Representative: Onsagers AS

(57) **Abstract**

A method for digital direct recording of an artwork representing electric connections of components on a substrate comprises the following steps:
a) receive data representing the artwork,
b) analyze the artwork representation to identify sections that are similar and sections that are unique and to identify locations of the components in the artwork,
c) divide the artwork into modules corresponding to the identified sections, providing a set of unique modules and a set of redundant modules,
d) rasterize each unique module to provide rasterized modules,
e) divide the rasterized modules into submodules,
f) receive measurements representing positions of the components on the substrate,
g) receive measurements representing the position of the substrate,
h) calculate the differences between the measured positions of the components and the artwork positions of the components,
i) calculate modifications for each of the sub modules to compensate for the differences, and
j) record the modified submodules onto the substrate to form a modified artwork on the substrate.

## Description

The present invention relates to a process to compensate for the positioning tolerance introduced when positioning electronic components (e.g. dies) on a substrate used in an e.g.fan-out panel level package (FOPLP) or fan-out wafer level package (FOWPL) process. When the electronic components are positioned by e.g. a pick and place machine with an offset or rotation compared to the nominal position, the artwork describing the electrical connections to the electronic components must go through an error-correction accordingly to provide proper electrical connection. This process is preferably performed in real time in order not to limit the throughput in a production line of electronic modules each containing one or multiple electronic components. The invention will contribute to increasing the yield during the manufacturing process as less of the electronic components have to be rejected due to bad positioning and hence lack of electrical connection without the drawback of having to generate a new rasterized artwork.

### BACKGROUND

The electronic components industry uses different technologies to achieve electrical connection between electronic components or modules of electronic components. In one embodiment, a substrate is used as a temporary carrier on which the components are placed in predefined positions using an adhesive tape. Each electronic component can for example be positioned with a "pick and place"-machine and this process will give some position and rotation error due to the accuracy limitations of such pick and place equipment where high speed and throughput are required. The electronic components are now over-molded with a compound, and in such molding process the electronic components might slightly move or rotate. Then the substrate and the adhesive tape are removed in a special process. The result is a compound layer with the electronic components and their electrical connections/pads visible from one side.

The electric connections between the components are then achieved by imposing a predefined artwork by e.g. light exposure on to a photosensitive material on top of the electronic components on the carrier substrate. If the positioning of the electronic components does not match the predefined artwork of electronic interconnection due to tolerances in the component placement process, the actual positions of the components need to be measured and the artwork needs to be error-corrected at some positions around the electronic components before imposing the artwork on to the components on the substrate to provide proper electric connection.

Several techniques have been identified to perform rearrangements of artwork. US8799845 and US4835704 describe a process where a completely new pattern is created for each substrate assembled with electronic components, based on the measurement of the actual electronic components position. US8799845 describe a process allowing routing of the tracks of electric connections in a totally new order, while US4835704 describe a process where parts of the tracks are rerouted. Both techniques will be time consuming as it requires a rerouting of the artwork and subsequent rasterization process of the artwork before the data is transferred to the recording device, e.g. a direct imaging machine that impose the pattern on to the substrate where the components will be mounted in a later stage of the process. Rerouting and rasterization process is time consuming, limiting the overall production process throughput. If the positioning of the electronic components is reasonable and within certain limits, rerouting is not required, and only error-correction of the rasterized artwork will be sufficient.

As it is desired to avoid any limitation in production time consumption due to the artwork error-correction, the predefined artwork needs to be preprocessed during an offline process in such a way so that the original artwork can be error corrected in real time when imposing the artwork, rather than creating a new artwork for each substrate to be produced.

In the following description, the term "artwork" refers to a design in the form of a database which describes interconnect structure and via hole structure for providing interconnects between electronic components. The term "rasterization" refers to the task of taking an image described in a vector graphics format (shapes) and converting it into a raster image, i.e. a series of pixels, dots or lines, which, when displayed together, create the image which was represented via shapes.

### SUMMARY OF THE INVENTION

The object of the invention is to provide a system and a method where a predefined artwork can be error corrected in real time during the process of recording the predefined artwork on to a substrate by means of a substrate recording machine on to a substrate. The substrate recording machine comprises a recording device unit comprising optical elements, for example photo heads or projectors that projects the artwork onto the substrate. In the following description, the term "photo head" will sometimes be used as a collective term comprising the optical elements of the exposure system and may be used interchangeably with the term recording device unit or recording unit.

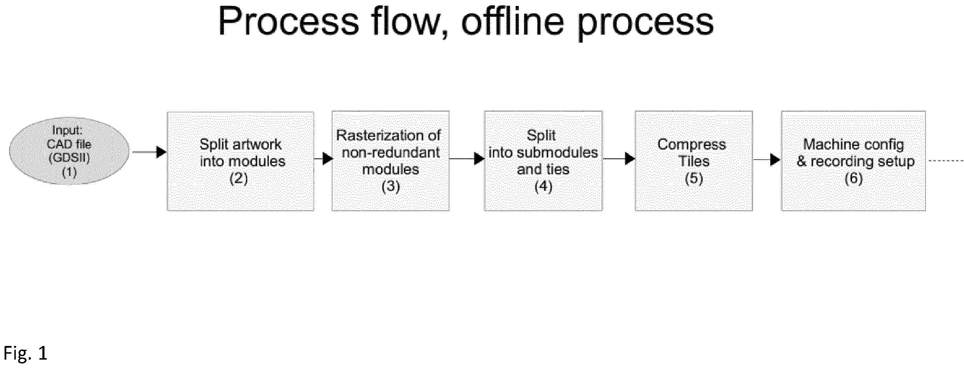

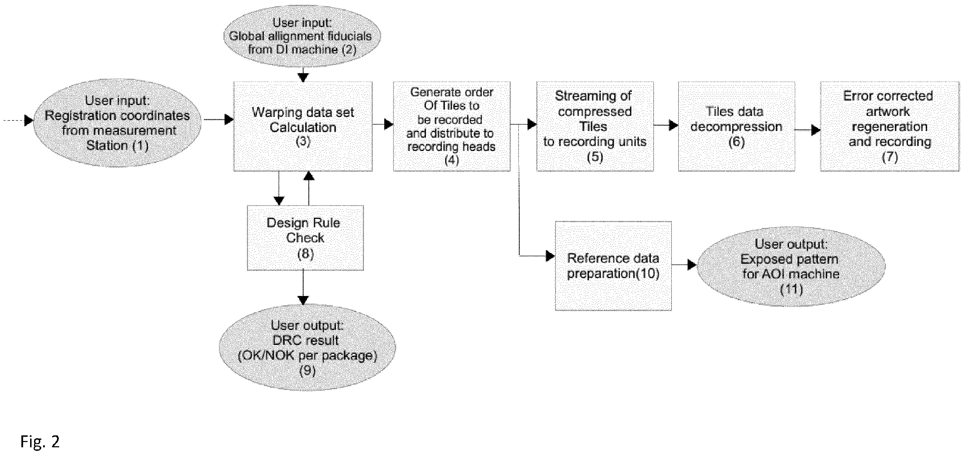

In order to achieve the real time requirement, the predefined artwork needs to undergo certain offline preprocessing steps and online real time processing steps as illustrated in FIGURE 1 and FIGURE 2. These steps will be described in more detail later. Offline processes are generally not performed during recording of the data onto a substrate and hence do not affect the overall throughput when recording several substrates. The offline process is performed prior to the online process and can be performed once per batch or group of substrate recordings, where the number of substrate recordings can be minimum one, but in most cases includes recording of multiple number of substrates using the same predefined artwork. The offline preprocessing steps include dividing the predefined artwork into a number of modules. The modules may comprise one or more levels of submodules inside. A predefined artwork used in a FOPLP/FOWLP application normally comprises a number of equal modules distributed over the substrate. Hence, all the modules in the predefined artwork can be represented by the module and a list of the positions of each of these modules over the predefined artwork instead of representing the artwork as one big file. Any additional parts of the predefined artwork that are not represented multiple times on the predefined artwork, such as frames or objects that are represented only once, can also be represented by a module with a list of its respective position on the predefined artwork module. Hence, the complete predefined artwork will be represented by a number of unique modules and a list of positions for each of these unique modules. As all equal modules can be rasterized only once instead of rasterizing the complete predefined artwork, the rasterization process will be shortened with a factor of 100 - 10000, as there can be 100 - 10000 equal modules in a predefined artwork. The rasterization process requires substantial CPU resources and will require a certain amount of processing time depending on available CPU resources. Hence it is of a general interest to minimize the amount of data to be rasterized to save processing time even if it is an offline process, as this will allow for prototype batches or groups of substrate recordings with low numbers of substrates per batch or group to be recorded within as little time as possible.

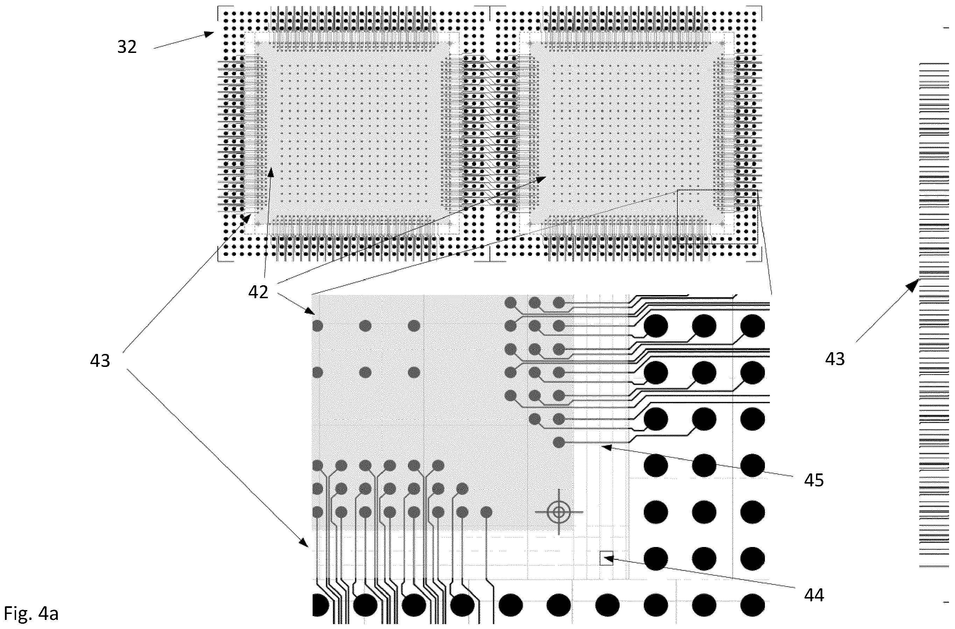

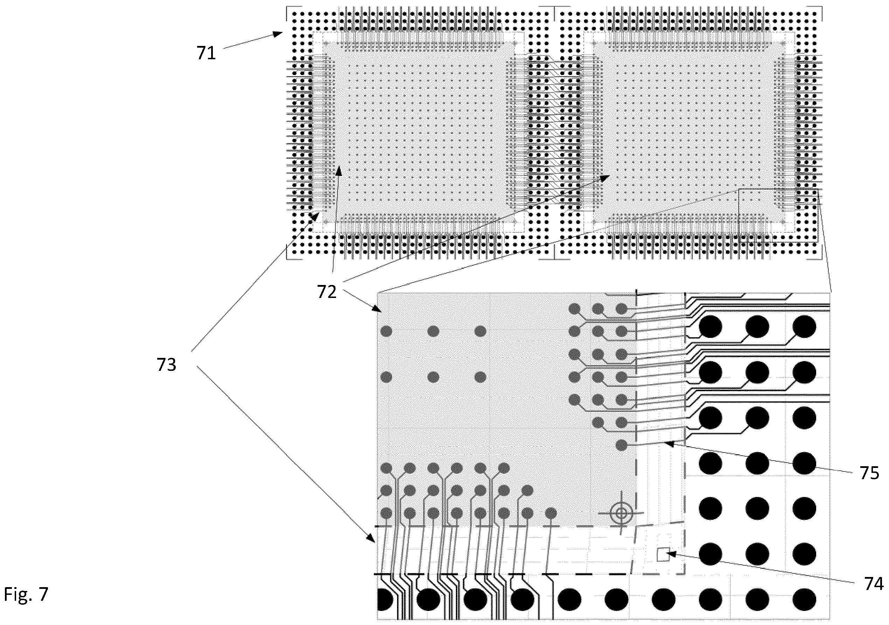

After rasterization, the preprocess includes division of the modules further into one or more submodules in one or multiple levels (FIGURE 4a). The size and the shape of the submodules varies depending on the properties for the area of the predefined artwork that is covered within the submodule. Such properties can include a description of to which extent scaling (warping) and positioning (rotation and offset) is allowed for each submodule. Each submodule can be divided into smaller submodules, until the lowest level of submodules is reached. The lowest level of submodule is in the following description referred to as Tiles. Each Tile is given a set of parameters that reflects the parameters for the submodule at the level above the Tile. The tiles are used as a basis for further processing of the predefined artwork in the offline process. For example can parts of the predefined artwork describe areas where electrical components are mounted. Such areas can be included in one submodule. The electrical components do not change shape but may be positioned (offset and rotated) differently from one substrate to another depending on the positioning tolerance of the placement machine. Thus, the artwork describing the electrical connection points to these components can only be positioned accordingly. This means that if scaling of such areas of the predefined artwork is applied, the electrical connections will not fit to the components that are to be connected. Thus, such areas covered with submodules will be represented by tiles that have parameters describing how much positioning must be applied to ensure correct electrical connection. Other submodules describe areas of the predefined artwork where there are electrical tracks connecting the electrical components together. In these submodules, the tracks can be error corrected during the online process to compensate for the positioning tolerance of the electronic components on the substrate. Thus, the tiles in these submodules have properties allowing both scaling and positioning to adjust the track positions slightly to provide correct electrical connection between the components (FIGURE 7).

In order to prepare for minimum delay during transfer of the tiles to the substrate recording machine, a lossless compression (e.g.Run Length Encoding) of the tiles can be performed before intermediate storage. At this stage, the configuration of the substrate recording machine parameters, such as initializing motion drives and recording parameters is performed.

The online process provides real time error correction and recording of the rasterized predefined artwork divided into tiles. The error correction is performed based on the input of measured position coordinates of multiple reference objects, such as local fiducial points for each module on a substrate, provided by e.g an external measurement machine. These position coordinates provide information on how the electronic components that are to be electrically interconnected are actually positioned on the substrate relative to each other. Also, the measured position coordinates providing information regarding the substrate's position inside the substrate recording machine, often called global fiducials, are used in the error correction. This can be done by means of an algorithm that calculates the required scaling and positioning of each Tile to provide correct error correction of the predefined artwork.

Based on the available machine configuration (e.g. number of recording heads in actual substrate recording machine and their internal distance) and the size of the actual substrate and artwork, the information required to perform recording of the error corrected artwork on to the substrate is requested by the recording device (e.g. one or multiple recording head(s)) from a Tile server. The tile server is where the Tiles are stored intermediately during the offline process. Also, the data containing information regarding the calculated scaling and positioning of each Tile is provided from the online warping calculation in order to provide error correction of the predefined artwork. When all Tiles are received by the recording device together with the position of each Tile and the scaling and positioning for each Tile, the recording of the complete error corrected artwork is enabled. Both global and local error correction can be performed simultaneously. An example of the resulting error corrected artwork is described in FIGURE 7, which will be described in more detail below.

### DETAILED DESCRIPTION

The invention will now be described in more detail by means of examples and with reference to the accompanying figures.
Figure 1 illustrates offline preprocessing steps according to an embodiment of the invention.
Figure 2 illustrates online real time processing steps according to an embodiment of the invention.
Figure 3 illustrates an example of a predefined artwork used in a FOPLP/FOWLP application.
Figure 4 illustrates a preprocess step of division of modules into one or more submodules in one or multiple levels.
Figure 5 shows an example of a list of positions for submodules.
Figure 6 shows an example of a list describing the calculated warping for submodules.
Figure 7 illustrates an error corrected artwork.
Figure 8 shows an embodiment where electrical components are interconnected or routed to another ReDistribution Layer (RDL) of electrical connections.
Figure 9 illustrates size variation of a submodule.
Figure 10 illustrates examples of design rules of an artwork.

An embodiment of the method according to the invention is illustrated in FIGURE 1 and FIGURE 2 with further illustrations in the other figures. The process is divided in an offline process illustrated in FIGURE 1 and an offline process illustrated in FIGURE 2.

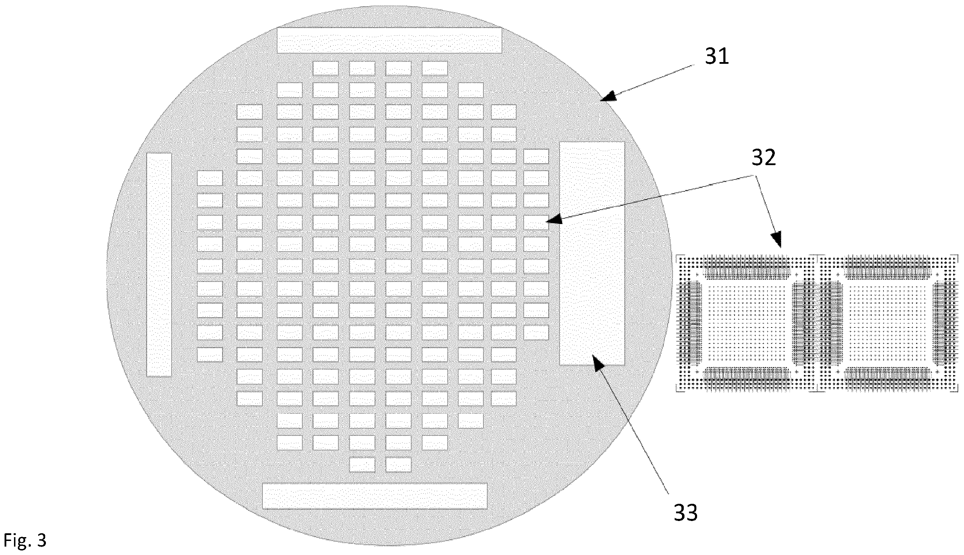

The overall offline process is set out in FIGURE 1. This process may be performed one time per batch or group of jobs. For each batch or group of jobs, there is a predefined artwork which is used for all the substrates to be used for recording of the particular artwork. An example of an artwork 31 is illustrated in FIGURE 3. The purpose of dividing the process into offline and online sections is to perform the process steps that only needs to be done one time per batch or group of jobs only once. These process steps will normally be time-consuming due to limited processing capability and it is therefore desired to perform these process steps outside the recording process, in order not to limit the overall recording throughput.

The offline process is normally performed as preprocessing steps before the online process steps illustrated in FIGURE 2.

The offline preprocessing steps includes in step (1) receiving data representing the artwork, for example as a CAD file, and in step (2) dividing the predefined artwork into a number of modules before the artwork is rasterized in step (3). The division of the predefined artwork 31 into modules 32, 33 is based on analyzing the artwork to identify sections that are similar and sections that are unique and to identify locations of the components in the artwork. The identification of similar or equal modules 33 provides modules that can be represented by one unique module and a list comprising the position of each of the equal, redundant modules in the predefined artwork 31. Non-redundant parts 33 of the predefined artwork, ie. unique modules of which there is only one, are also represented by a module with a list of their position in the predefined artwork 31. As the unique modules are rasterized only once instead of rasterizing all the redundant modules in the complete predefined artwork, the rasterization process will be reduced in time with a factor of 100 - 10000, as there can be 100 - 10000 equal modules in a predefined artwork. Another advantage when splitting the predefined artwork into modules, is that the open areas between the modules do not need to be rasterized, only the areas that contains artwork. Thus, the process of creating modules out of the predefined artwork saves processing time during rasterization. This is desired even if it is an offline process, especially when recording the artwork on small prototype batches or groups of recording substrates.

After rasterization of the non-redundant modules 32, 33 the modules are divided into submodules in one or multiple levels. Different levels means that one submodule can be inside another submodule and a part of the other submodule. The size of a submodule may vary and can in some instances be wider than the width of the working area of the recording device unit/photo head in a substrate recording machine.

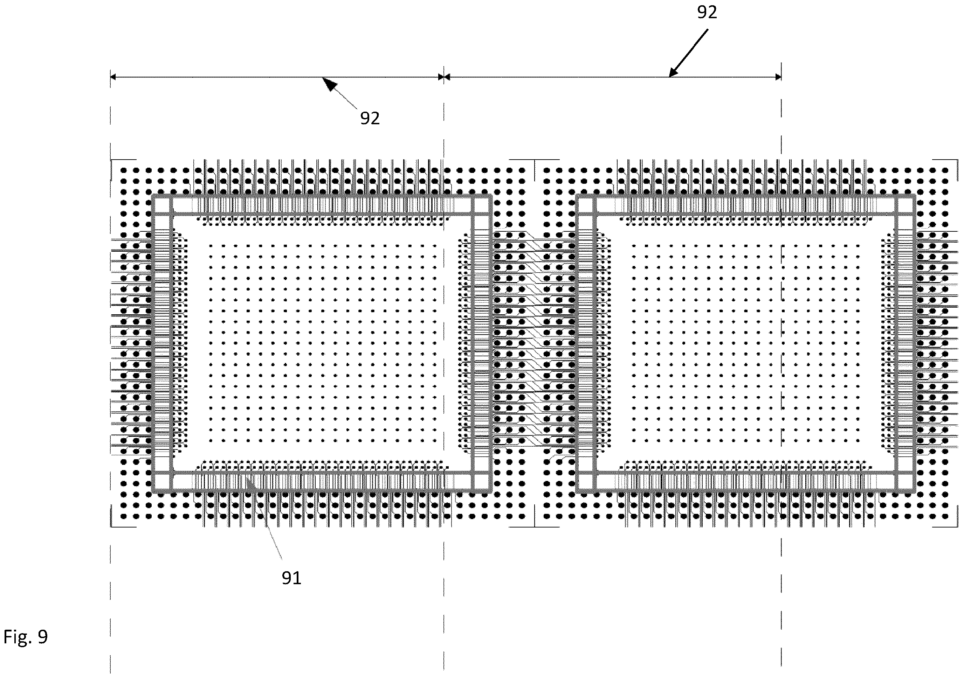

This is illustrated in FIGURE 9 where the width of the submodule 91 is larger than the width 92 which can be covered by the projection by the recording device unit. Thus, to record the full width of the submodule, there may be used several recording device units/photo heads. To achieve this the substrate recording machine may comprise several photo heads.

To limit data transfer to each recording unit inside the substrate recording machine, the submodules may be represented in a flexible format that allows for efficient transfer and minimum processing in the recording device unit. This is solved by splitting each of the submodules into a set of submodules at a lower level, where the submodules at the lower level are smaller than the submodules at a level above.

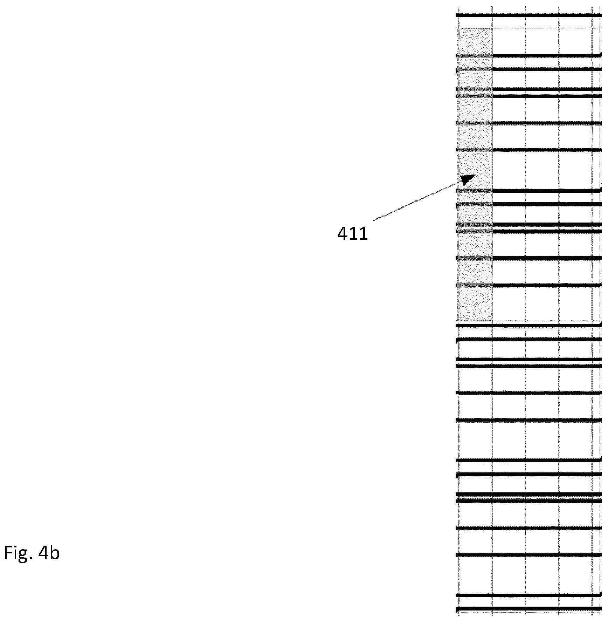

The submodules are illustrated in FIGURE 4a and 4b. The submodule at the lowest level 44, 411 which comprise the actual rasterized bitmap data is referred to as a Tile and has a minimum size of 2x2 pixels. This submodule (Tile) is used as a building block for further processing in the offline and online processes. Each of the Tiles represents one or more defined limited areas 43 of the overall predefined artwork that has electrical connections (e.g. pads or vias) to an electronic component (e.g. an electronic die), where internal relative distance and positioning of the electrical connections normally is only offset or rotated, and if so, only slightly scaled or distorted to adapt to the relative displacement between components and surrounding layout.

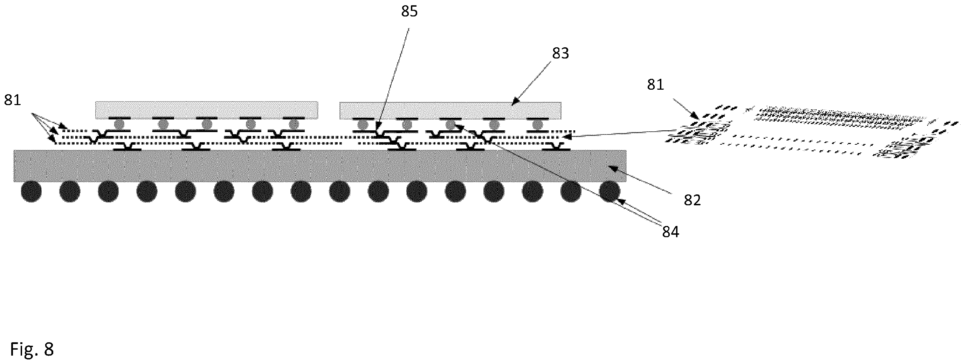

Figure 8 illustrates an example where a Tile is part of a ReDistribution Layer (RDL) 81 in a FOPLP/FOWLP application.

In this case, a Tile can be defined as a limited area of the overall predefined artwork of a module where all or some of the electrical components are interconnected or routed to another ReDistribution Layer (RDL) of electrical connections through electrical vias 85. The electrical component, e.g. a die 83 can then be electrical connected to the substrate 82 using solder balls 84 towards the upper RDL. This stack of RDLs allows that all electrical signals from the die are connected to the substrate while still keeping the size of the total package small. In such a structure, the internal relative distance and positioning of the electrical connections on each RDL is normally only offset and/or rotated and if so, only slightly scaled or distorted to fit to other RDLs.

The size of a Tile 44, 411 is square or rectangular depending on what is optimal to cover the area of the submodule at the higher level. There may also be other suitable shapes for the Tiles, to optimize the adaption to the area to be covered. Also, the size and shape will depend on what is allowed in the defined data protocol for image data transfer to the recording device. In addition, the Tiles inherits information from the submodule at a higher level on how they are allowed to be reshaped in the output on the recording device, ie. during recording.

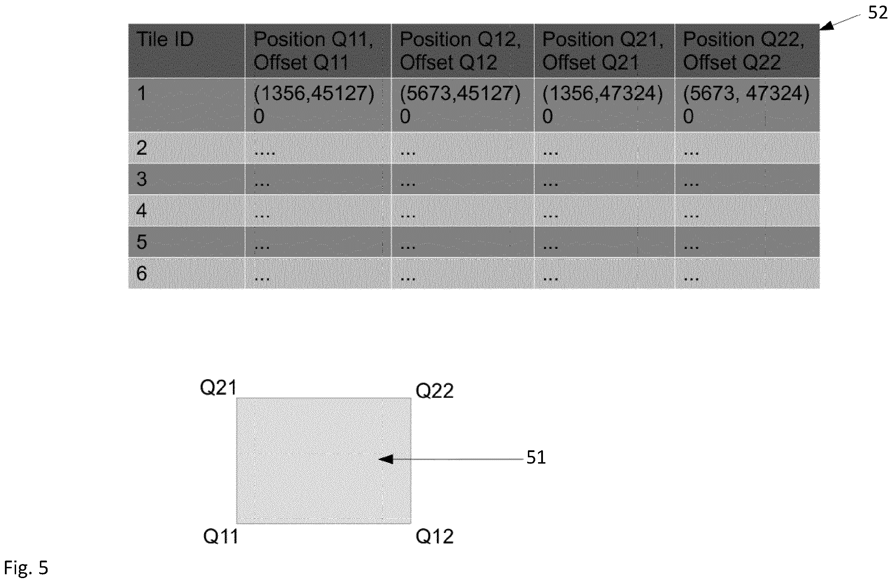

When the Tiles have been defined, the offline preprocessing step (5) of FIGURE 1 includes a data compression of each of the Tiles. The data compression of the Tiles can be performed using a lossless compression algorithm to obtain minimum transfer time during the subsequent online process of FIGURE 2. Also, a list of positions for each Tile is generated. An example of such a list is shown in FIGURE 5.

The last step (6) of the offline process illustrated in figure 1 includes configuring the substrate recording machine to prepare for general recording parameters, such as e.g. setup of motion drives and recording energy parameters. This can be done during the offline process and prior to each batch or group of jobs where each batch/group includes a number of substrates to be recorded.

The online process illustrated in FIGURE 2 is initiated by step (1) comprising the input of measured position coordinates of multiple reference objects, such as local fiducial points provided by e.g an external measurement machine. These position coordinates provide information on how the electronic components to be electrically interconnected are positioned on the substrate relative to each other. In addition, in step (2) measured position coordinates providing information on how the actual substrate is positioned inside the substrate recording machine, often called global fiducials, are communicated as input to step (3). Step (3) comprises calculation of error correction parameters or warping data set of each submodule.

By using these position measurement data, the artwork can be corrected both locally and globally at the same time. This is performed as the global measured position coordinates from the recording machine will be used to recalculate the local corrections with respect to the substrate recording machine coordinate system. Such correction calculations are typically performed with a bi-linear, spline or similar suitable interpolation method. The recalculated local corrections are then used to calculate the offset and distortion of each Tile in their respective sub-module. When the Tiles and the corresponding list 52 describing the warping of each Tile is transferred to each recording device unit of a substrate recording machine, the internal relative position of the respective recording unit is also compensated to create an overall artwork with no overlaps or gaps between the recorded results of each recording unit inside the substrate recording machine.

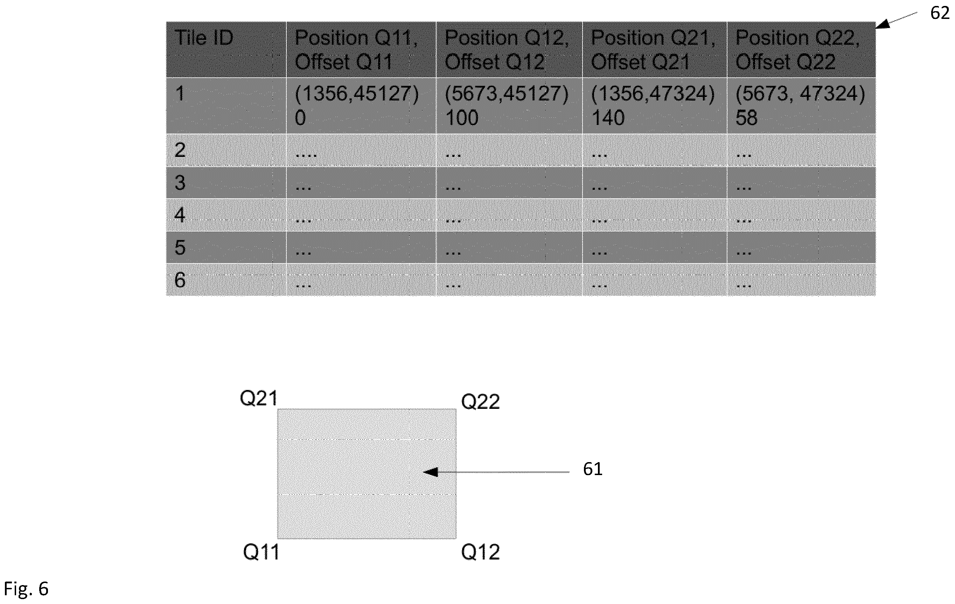

In step (4) of the online process, there is generated an order of Tiles to be recorded and distributed to the recording units. The order is generated based on the available machine configuration such as number of recording heads in actual substrate recording machine and their internal distance, and the size of the actual substrate and artwork. The order comprises:
a) The Tiles required to perform recording of the error corrected predefined artwork on to the substrate;
b) A list describing the calculated warping for Tile, represented by an offset in x and y for each corner of each Tile. An example of such a list is illustrated in FIGURE 6.

When the complete order of Tiles is prepared, the Tiles and the list of Tile warping information are transferred to the substrate recording machine. In order to obtain the real time requirement with minimum delay before recording in the online process, the Tiles are transferred in step (5) in the same order as they are recorded. This is often referred to as a streaming process. As each Tile is compressed during the offline process (FIGURE 1, step (5)) to save transfer time during streaming of the Tiles, they will be decompressed in step (6) after the reception by the substrate recording machine. In step (7), the substrate recording machine will place the Tiles in the correct position and perform warping as described in the list of Tile warping information and record the result on to the substrate.

FIGURE 7 illustrates the resulting error corrected recorded artwork which comprises modules 71, with the submodules 72, 73 and warped Tiles 74, 75. The electronic tracks in the predefined artwork have been error corrected compared to the tracks 45 described in FIGURE 4a, as each Tile 44, 411 inside of the submodule has been warped according to the list 62 describing the calculated warping for each Tile to achieve the shape described in 74. The coordinates of the corners of each Tile 61 are given in pixels or decimals of a pixel in the bitmap domain of the rasterized predefined artwork. The process steps (3), (4), (5) and (6) described in FIGURE 2 are performed within milliseconds, representing a real time process, as the recording process in step (7) use several seconds depending on the recording substrate properties. Hence, the real time error correction during recording according to the invention represents a major improvement compared to e.g. US8799845 and US4835704.

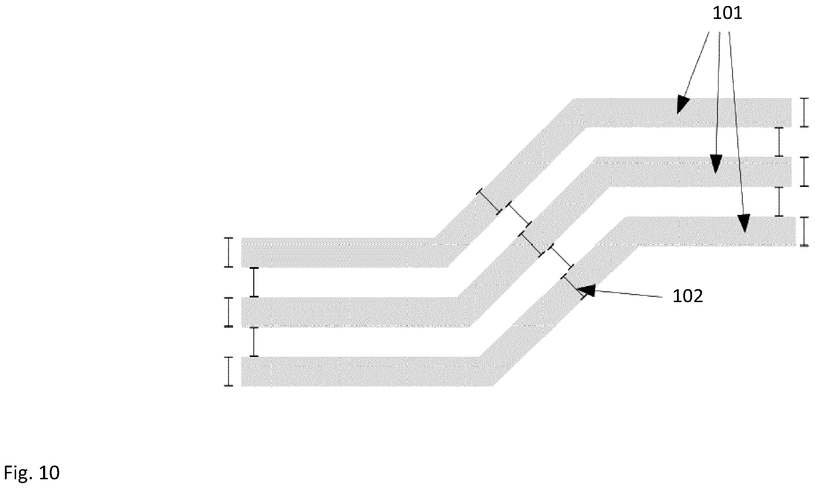

During the calculation of the warping set in step (3), a control can be performed in step (8) with respect to a predefined set of design rules, set by the user. (Design Rule Check). Examples of items for such design rules are illustrated in FIGURE 10-Such design rules may comprise information on e.g. allowed line width tolerances 101 and line space tolerances 102 of the artwork. For each of the Tiles, a check can be performed of whether the applied warping (scaling and positioning) described in the list 62 of FIGURE 6 is according to the predefined design rules. If this is not the case, the information describing which of the Tiles that does not fulfill the design rules is communicated to the user in step (9) so that the user can take proper actions. Such actions may include aborting the recording process, or, if the recording process is allowed, to discard only the areas of the recording that is not within the design rules.

After the recording process step (7), the recorded substrate can undergo a visual inspection in e.g. an external Automatic Optical Inspection (AOI) machine. Such inspection may utilize reference data from the recording machine, and hence the recording machine must prepare the data used for recording in step (10) in such a way so that it can be utilized by the AOI machine in a step (11).

## Claims

1. Method for digital direct recording of an artwork representing electric connections of components on a substrate, comprising the following steps:
a) receive data representing the artwork,
b) analyze the artwork representation to identify sections that are similar and sections that are unique and to identify locations of the components in the artwork,
c) divide the artwork into modules corresponding to the identified sections, providing a set of unique modules and a set of redundant modules,
d) rasterize each unique module to provide rasterized modules,
e) divide the rasterized modules into submodules,
f) receive measurements representing positions of the components on the substrate,
g) receive measurements representing the position of the substrate,
h) calculate the differences between the measured positions of the components and the artwork positions of the components,
i) calculate modifications for each of the sub modules to compensate for the differences, and
j) record the modified submodules onto the substrate to form a modified artwork on the substrate.

2. Method according to claim 1, comprising a step where the submodules are divided into further levels of submodules and lower level submodules represents smaller areas.

3. Method according to claim 2, where the submodules are analyzed to identify subsections having specific characteristics.

4. Method according to claim 3, where the characteristics is one or a combination of the following:
- areas where relative distance of elements in the artwork must be maintained,
- areas where relative distance of elements in the artwork can be scaled or distorted,
- areas that represents larger areas than can be recorded in one operation.

5. Method according to one of the previous claims, where each redundant module is represented by a unique module and a position and where a list is generated comprising instructions for modification for each module.

6. Method according to one of the previous claims, where the modification of the data representing the artwork is performed with respect to predetermined design rules.

7. Method according to one of the previous claims where the measurement of step f) is received from a remote measurement station.

8. Method according to one of the previous claims, where the measurements of step g) is received from an internal measurement system.

9. System for digital direct recording of an artwork representing electric connections of components on a substrate, comprising a substrate recording machine comprising a recording device unit, and measurement means for measuring positions of the components on the substrate and/or the position of the substrate, where the substrate recording machine comprises
- memory means adapted to receive and store data representing the artwork, and
- a processing device adapted for
- analyzing the artwork representation to identify sections that are similar and sections that are unique and to identify locations of the components in the artwork,
- dividing the artwork into modules corresponding to the identified sections, providing a set of unique modules and a set of redundant modules,
- rasterizing each unique module to provide rasterized modules,
- dividing the rasterized modules into submodules,
- receiving measurements representing positions of the components on the substrate,
- receiving measurements representing the position of the substrate,
- calculating the differences between the measured positions of the components and the artwork positions of the components,
- calculating modifications for each of the sub modules to compensate for the differences, and
- sending the modified submodules to the recording device unit for recording onto the substrate to form a modified artwork on the substrate.

10. System according to claim 9, where the processing device is further adapted for dividing submodules into further levels of submodules and lower level submodules represents smaller areas.

11. System according to claim 9 or 10, where the processing device is adapted to analyze the submodules to identify subsections having specific characteristics.

12. System according to one of the claims 9 to 11, where each redundant module is represented by a unique module and a position and where a list is generated comprising instructions for modification for each module.

13. System according to one of the claims 9 to 12, comprising a remote measurement station for measurements representing positions of the components on the substrate.

14. System according to one of the claims 9 to 12, where the substrate recording machine comprises an internal measurement system for making measurements representing the position of the substrate.
